# EUROPEAN PATENT APPLICATION

(11) **EP 0 744 770 A2**
(43) Date of publication of application: **27.11.1996**
(21) Application number: 96303575.3
(22) Date of filing: 20.05.1996
(51) Int. Cl.: H01L 27/02

(54) **Semiconductor apparatus**

(30) Priority: 23.05.1995 JP 123311/95
(71) Applicant: FUJI ELECTRIC CO. LTD., Kawasaki 210 (JP)
(72) Inventor: Nishiura, Akira, c/o Fuji Electric Co. Ltd., Kawasaki-ku, Kawasaki 210 (JP); Fujihira, Tatsuhiko, c/o Fuji Electric Co. Ltd., Kawasaki-ku, Kawasaki 210 (JP)
(74) Representative: Topley, Paul

(57) **Abstract**

To provide a semiconductor apparatus which mounts an insulated gate semiconductor device and its temperature sensing element (temperature sensor) on one single semiconductor substrate to protect the semiconductor device from overheating accurately in a short time.

The present semiconductor apparatus includes a lightly doped n-type semiconductor substrate (1); a p-type well region (2) in a first surface portion of substrate (1); an n-type emitter region (3) in p-type well region (2); a gate electrode above p-type well region (2); an emitter electrode (6) on n-type emitter region (3) and a contact region (20) of p-type well region (2); a p+ or n+ collector region (7) on a back surface of substrate (1); a collector electrode (8) on collector region (7); an anode region (9) in a second surface portion of substrate (1); a cathode region (10) in anode region (9); an anode electrode (11) on anode region (9); and a cathode electrode (12) on cathode region (10). Anode region (9) and cathode region (10) constitute a temperature sensor. Anode electrode (11) is connected to a temperature detecting terminal (15), and cathode electrode (12) to emitter electrode (6).

## Description

The present invention relates to an insulated gate semiconductor apparatus which is capable of a temperature sensing function.

In these days, many types of intelligent power modules (hereinafter referred to as an "IPM") are used, which include an insulated gate semiconductor device such as an insulated bipolar transistor (hereinafter referred to as an "IGBT") or a MOSFET as their power device. These IPMs incorporate various sensing elements, one of which may be a temperature sensor, and incorporate such sensors with an insulated gate semiconductor device in one single package. Usually, a thermistor is used as the temperature sensor for the IPMs. The thermistor is bonded to a metal base, to which a chip of the insulated gate semiconductor device is also bonded, to detect the temperature of the insulated gate semiconductor device.

Recently, capacity of the IPMs has been increasing. Usually, six insulated gate semiconductor devices are mounted within a package. If one thermistor is used for sensing the temperatures of the six semiconductor devices, it is impossible accurately and quickly to detect the actual temperatures of the semiconductor devices positioned away from the thermistor. Thus, a single thermistor is not enough to prevent multiple semiconductor devices from overheating. However, if multiple thermistors are used in order quickly to detect the temperatures of the respective insulated gate semiconductor devices, the cost of the IPM increases greatly.

In view of the foregoing, it is an object of the present invention to provide a semiconductor apparatus in which an insulated gate semiconductor device and its temperature sensor are mounted on a single semiconductor substrate to protect the semiconductor device accurately and quickly from overheating.

According to an aspect of the present invention, there is provided a semiconductor apparatus which includes a semiconductor substrate of a first conductivity type; an insulated gate semiconductor device including a well region of a second conductivity type in a first surface portion of the semiconductor substrate, an emitter region of the first conductivity type in the well region, and an emitter electrode on the emitter region; and a pn diode including an anode region of the second conductivity type selectively formed in a second surface portion of the semiconductor substrate, the anode region being separated laterally from the well region, an anode electrode on the anode region, a cathode region of the first conductivity type selectively formed in the anode region, and a cathode electrode on the cathode region, the cathode electrode being connected to the emitter electrode.

According to another aspect of the present invention, there is provided a semiconductor apparatus which includes a semiconductor substrate of a first conductivity type; an insulated gate semiconductor device including a well region of a second conductivity type in a first surface portion of the semiconductor substrate, an emitter region of the first conductivity type in the well region, and an emitter electrode on the emitter region; two or more pn diodes in a second surface portion of the semiconductor substrate, the pn diodes being separated apart laterally from the insulated semiconductor device, each of the two or more pn diodes including an anode region of the second conductivity type, an anode electrode on the anode region, a cathode region of the first conductivity type selectively formed in the anode region, and a cathode electrode on the cathode region; and metal films selectively formed on the semiconductor substrate with an insulation film interposed in-between, each of the metal films connecting the anode electrode of one of the two or more pn diodes to the cathode electrode of an adjacent one of the two or more pn diodes to connect the two or more pn diodes in series.

Advantageously, the well region and anode region have the same dopant concentration and the same depth; and the emitter region and cathode region also have the same dopant concentration and the same depth.

It is preferable to form each cathode region concentrically with its associated pairing anode region.

Advantageously, the semiconductor apparatus is provided with a region of the second conductivity type surrounding the anode region or the anode regions, the region of the second conductivity type being spaced apart laterally from the insulated gate semiconductor device; and with a metal electrode on the region of the second conductivity type connected to the emitter electrode and the cathode electrode or the cathode electrode located at an end of the series connection of the pn diodes.

Advantageously, the semiconductor apparatus is further provided with an anode terminal connected to the anode electrode or the anode electrode located at an end of the series connection of the pn diodes; an emitter terminal connected to the emitter electrode; a constant current supply including a positive electrode connected to the anode terminal, and a negative electrode connected to the emitter terminal to make a current flow from the anode region to the cathode region of each pn diode; and a temperature sensing terminal for sensing the lateral insulated gate semiconductor device's temperature from the voltage drop across the pn diode or the pn diodes connected in series, the temperature sensing terminal being connected to the anode electrode or the anode electrode at the end of the series connection of the pn diodes.

By integrating an insulated gate semiconductor device as a power device and a temperature sensor on one single semiconductor substrate, the heat generated in the power device is conducted to the temperature sensor in a short time with less dissipation. A pn diode is formed as the temperature sensor on the semiconductor substrate. The forward voltage of the pn diode (voltage drop across the pn diode) drops with increasing temperature. Therefore, the temperature of the power device is measured by feeding a small current from a constant current supply to the pn diode and by detecting the forward voltage of the pn diode. By connecting multiple pn diodes in series, a total forward voltage (voltage drop across the pn diodes) and therefore a total voltage change with temperature are multiplied to facilitate detecting the temperature more accurately.

The present invention will now be described in detail, with reference to the accompanying drawings, which illustrate preferred embodiments of the present invention. In the drawings:

Figure 1 is a cross section of a first embodiment of a semiconductor apparatus according to the present invention.

Figure 2(a) is a cross section for explaining a manufacturing process of p-type impurity doping.

Figure 2(b) is a cross section for explaining a manufacturing process of n-type impurity doping.

Figure 3(a) is a top plan view showing a main portion of a second embodiment of a semiconductor apparatus according to the invention.

Figure 3(b) is a cross section taken along A-A of Figure 3(a).

Figure 4 is a cross section of the second embodiment including the partial cross section shown in Figure 3(b).

Figure 5 is a cross section of a third embodiment of a semiconductor apparatus according to the invention.

Figure 6 is an equivalent circuit diagram of Figure 5.

Figure 7 is an equivalent circuit diagram of a fourth embodiment of a semiconductor apparatus according to the invention.

Figure 8 is an equivalent circuit diagram of the semiconductor apparatus of Figure 4 including p-type regions.

Figure 9(a) is a set of curves relating the forward voltage of the temperature sensor with the forward current of up to 20 mA with the temperature as a parameter.

Figure 9(b) is a set of curves relating the forward voltage of the temperature sensor with the forward current of up to 2 mA with the temperature as a parameter.

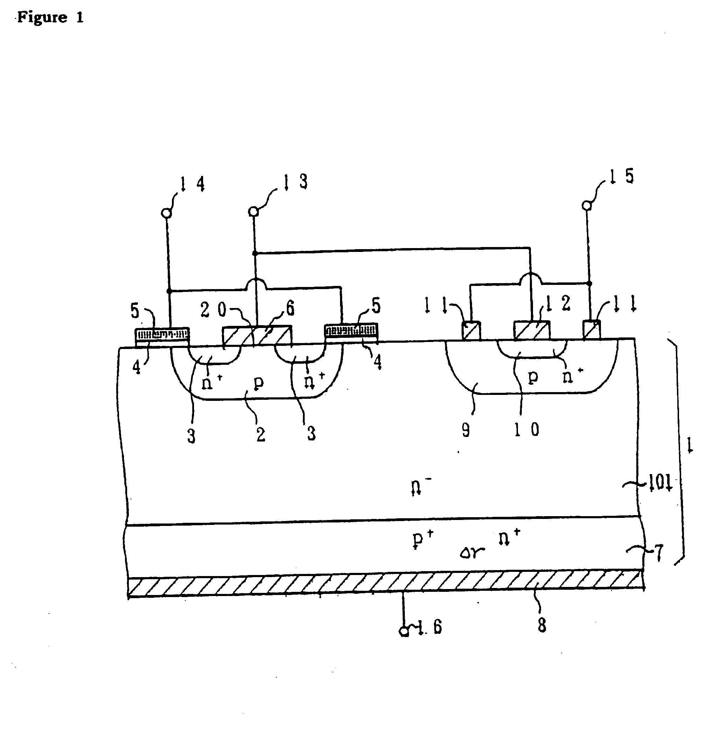

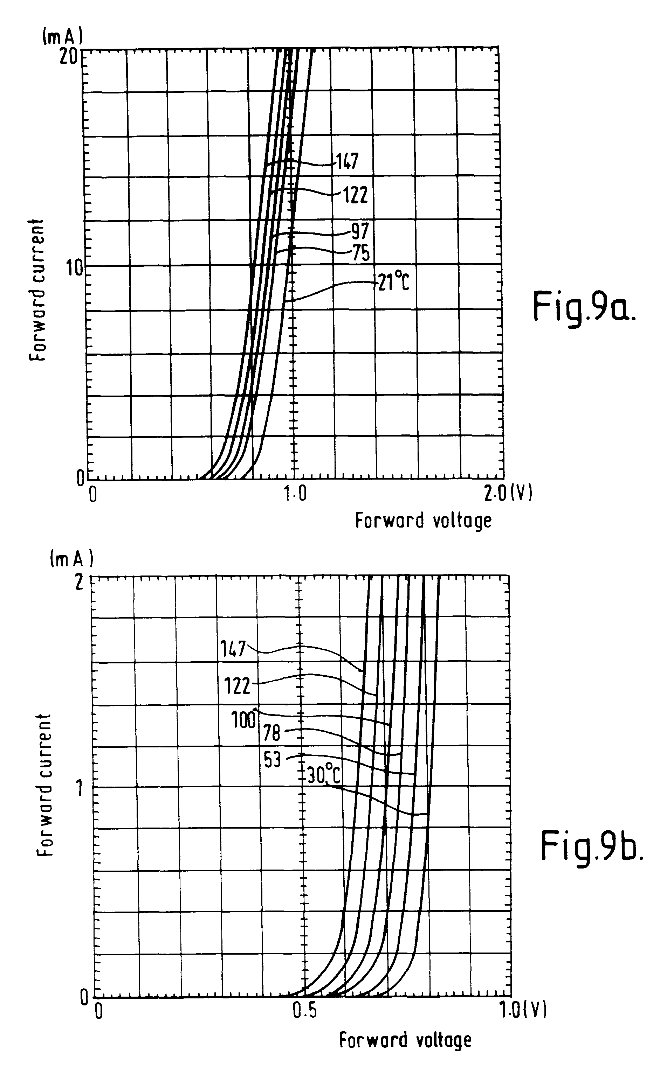

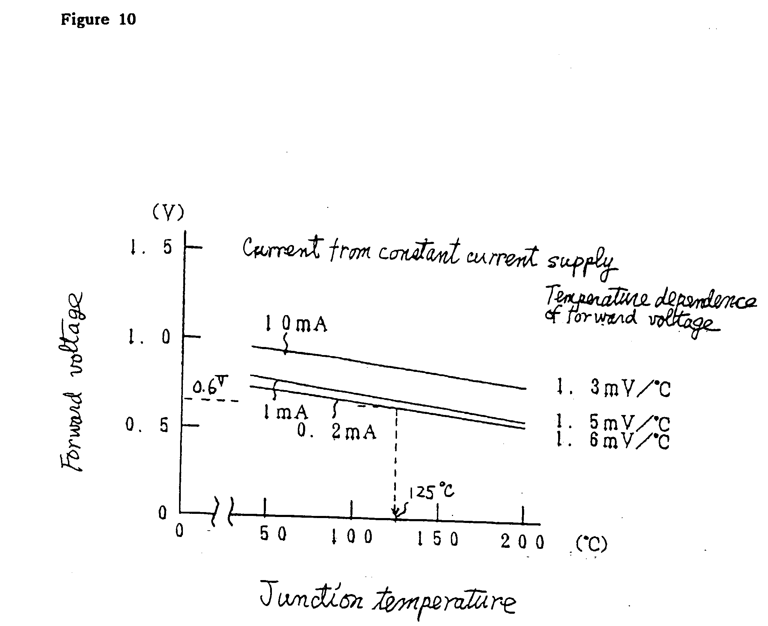

Figure 10 is a graph relating the forward voltage with the junction temperature on the bases of the data of Figs. 9(a) and 9(b). Figure 1 is a cross section of a first embodiment of a semiconductor apparatus according to the present invention. Referring to Figure 1, this semiconductor apparatus uses a lightly doped n-type substrate 1. After all the pertinent semiconductor regions are formed, n-type substrate 1 turns out to be an n- region 101. A p-type well region 2 is selectively formed in a first surface portion of n-type substrate 1. An n+ emitter region 3 is selectively formed in a surface portion of p-type well region 2. A gate electrode 5 is fixed via a gate insulation film 4 to that portion of p-type well region 2 separating n+ emitter region 3 and n- region 101 from each other. An emitter electrode 6 is disposed on n+ emitter region 3 and on a central contact region 20 on p-type well region 2.

A p+ or n+ collector region 7 is disposed on a rear surface (the undersurface as seen in the Figure) of n-type substrate 1. A collector electrode 8 is disposed on the collector region 7.

A p-type anode region 9 is selectively formed in a second surface portion of n-type substrate 1. P-type anode region 9 is spaced apart from p-type well region 2 by an area of n- region 101. An n-type cathode region 10 is formed in a surface portion of p-type anode region 9. An anode electrode 11 is positioned on p-type anode region 9, and a cathode electrode 12 is positioned on n-type cathode region 10. P-type anode region 9 and n-type cathode region 10 constitute a pn diode as a temperature sensing element (temperature sensor).

Cathode electrode 12 is connected to emitter electrode 6, and both are connected to an emitter terminal 13. Gate electrode 5 is connected to a gate terminal 14. Anode electrode 1 1 is connected to a temperature sensing terminal 15. Collector electrode 8 is connected to a collector terminal 16.

In the structure described above, when the collector region 7 is a p+ type one, that is when the power device is an IGBT, an npnp quadruple-layered structure (a parasitic thyristor), consisting of n-type cathode region 10, p-type anode region 9, n+ region 101, and p+ collector region 7, is formed. However, since a pn junction between p-type anode region 9 and n-type cathode region 10 is doped very heavily, electron injection from the n-type cathode region 10 is suppressed. For example, even when a current of from several mA to several tens of mA is made to flow from p-type anode region 9, latching-up does not occur at the p-n junction between p-type anode region 9 and n-type cathode region 10. On the other hand, when the collector region 7 is an n+ type one, that is when the power device is a MOSFET, the parasitic thyristor described above which might cause latching-up is not formed.

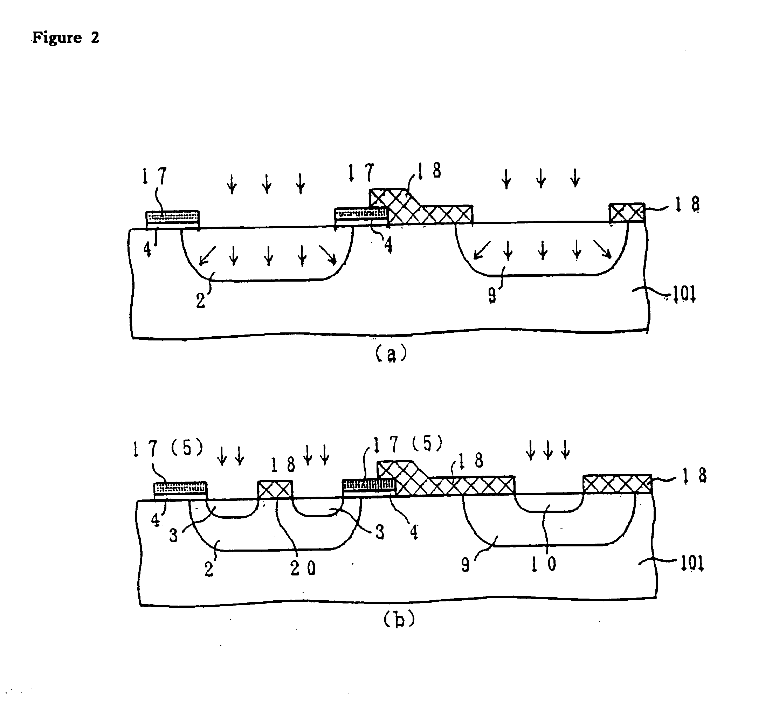

Figure 2(a) is a schematic cross sectional view for explaining the manufacturing process employing p-type impurity doping. Figure 2(b) is a schematic cross section for explaining a manufacturing process employing n-type impurity doping.

Referring to Figure 2(a), boron (B) ions are selectively implanted into regions of the surface of the substrate 1. Then, the implanted B ions are thermally diffused to simultaneously form the p-type well region 2 and the p-type anode region 9. A poly-crystalline silicon film 17 which will be gate electrode 5 is used as an ion implantation mask for forming p-type well region 2. A photoresist film 18 is used as an ion implantation masking for forming p-type anode region 9.

Referring to Figure 2(b), arsenic (As) ions are selectively implanted into regions of the surface of p-type well region 2 and p-type anode region 9 to simultaneously form n+ emitter region 3 and n-type cathode region 10. Poly-crystalline silicon film 17 which will be gate electrode 5 and photoresist film 18 are used as an ion implantation masking to define the outline for forming n+ emitter region 3. A photoresist film 18 is used as an ion implantation mask for forming n-type cathode region 10. The region of the surface which contains n-type cathode region 10 constitutes a temperature sensor.

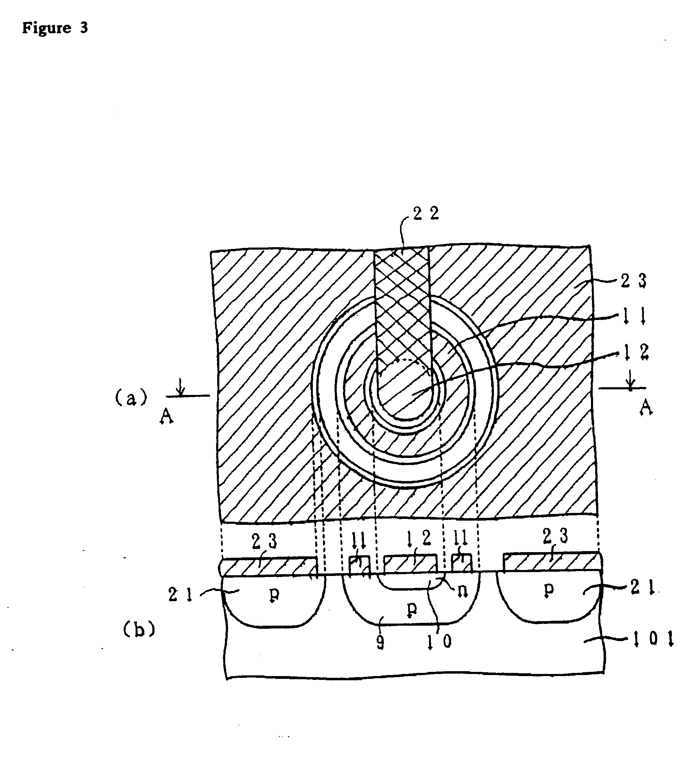

Figure 3(a) is a top plan view showing a main portion of a second embodiment of a semiconductor apparatus according to the invention, and Figure 3(b) is a cross section taken along A-A of Figure 3(a). An n-type cathode region 10 and a p-type anode region 9 are formed concentrically with each other. A p-type region 21 surrounds p-type anode region 9. A cathode electrode 12 is formed on the n-type cathode region 10. A cathode electrode 12 is connected to an emitter electrode of an IGBT (not shown) via a metal film 22. An anode electrode 11 is formed on anode region 9. A metal electrode is on p-type region 21. Metal film 22 is insulated from anode electrode 11, metal electrode 23, and semiconductor substrate 1 by an inter-layer insulation film (not shown). A collector region is omitted from Figure 3(b).

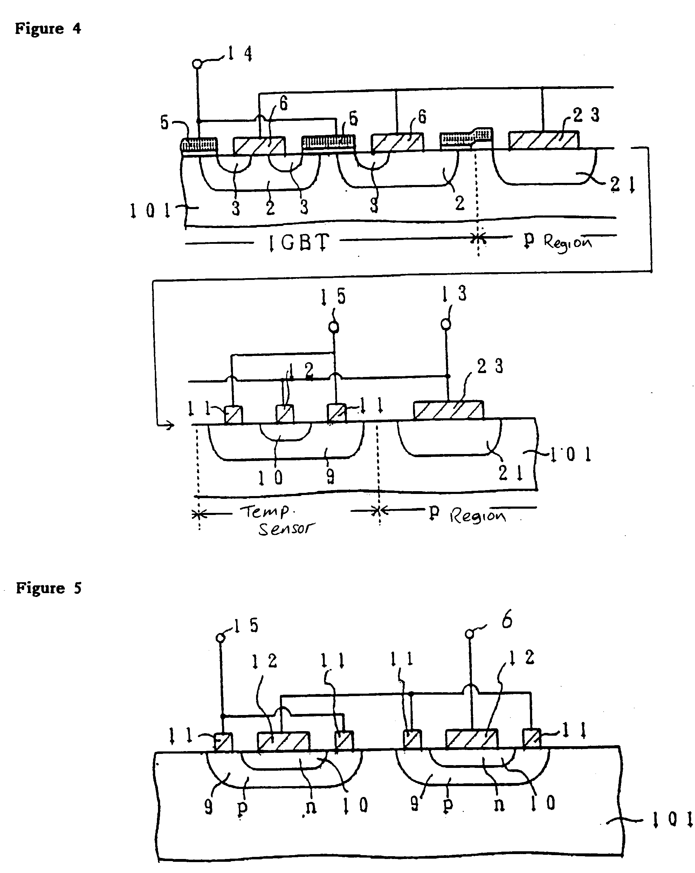

Figure 4 is a cross section of the second embodiment including the partial cross section shown in Figure 3(b). The collector region is omitted from Figure 4. Cathode electrode 12, metal electrode 23 and emitter electrode 6 are connected to one another via the metal film 22 shown in Figure 3(a), and also to an emitter terminal 13. An anode electrode 11 is connected to a temperature sensing terminal 15. From left to right in the Figure, there are seen an IGBT portion, a p-type region, a temperature sensor, and a further p-type region. In Figure 4, the left hand side and right hand side of the semiconductor apparatus are shown separately only for the sake of illustration convenience.

Figure 5 is a cross section of a third embodiment of a semiconductor apparatus according to the invention. The third embodiment connects two pn diodes in series to constitute a temperature sensor. A cathode electrode 12 of a first pn diode is connected to an anode electrode 11 of a second pn diode. An anode electrode 11 of the first pn diode is connected to a temperature sensing terminal 15. A cathode electrode 12 of the second pn diode is connected to an emitter electrode 6. A collector region is omitted from Figure 4. Three or more pn diodes may be connected in series, to increase the sensitivity of the temperature detection.

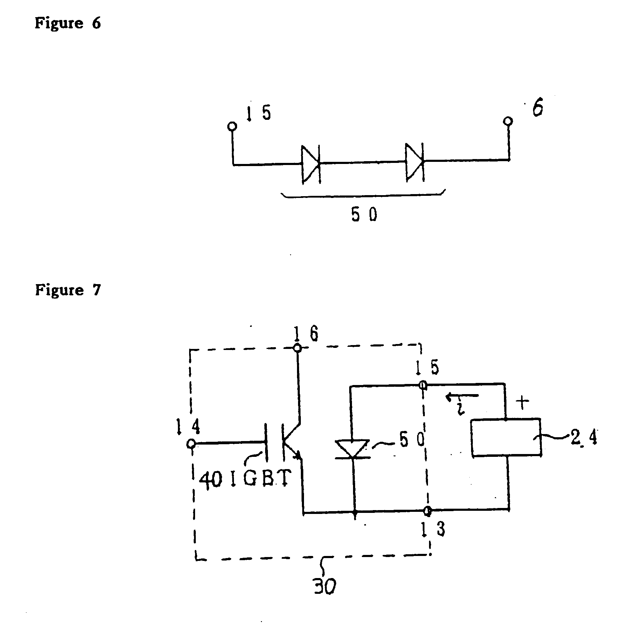

Figure 6 is a circuit diagram of the circuit of Figure 5. An anode side of a temperature sensor 50 is connected to temperature sensing terminal 15, and a cathode side thereof to emitter electrode 6.

Figure 7 is an equivalent circuit diagram of a fourth embodiment of a semiconductor apparatus according to the invention. A constant current supply is also shown in the Figure. A semiconductor apparatus 30 is in an area surrounded by broken lines with an IGBT 40 arranged on the left hand side therein. A temperature sensor 50 which comprises a pn diode is positioned adjacent to IGBT 40. A temperature sensing terminal 15 is connected to a positive electrode of a constant current supply 24, and an emitter terminal 13 to a negative electrode thereof to make a small current flow from an anode of the pn diode to its cathode.

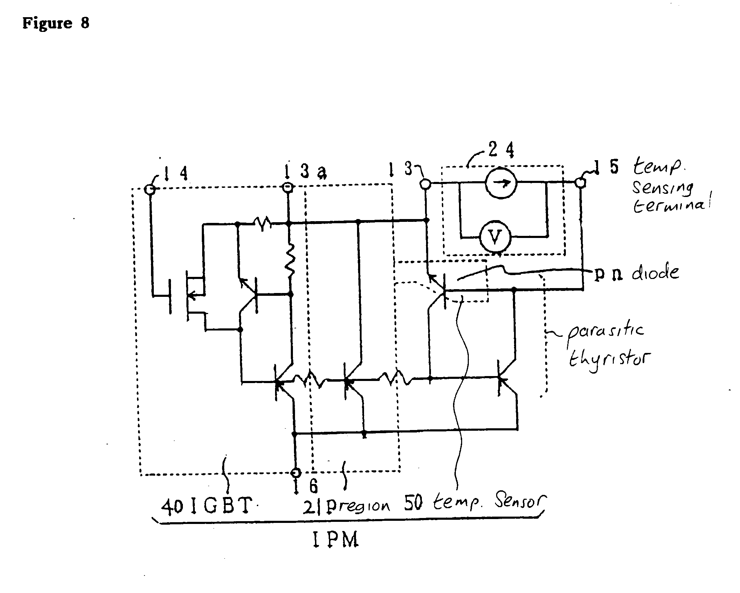

Figure 8 is an equivalent circuit diagram of the semiconductor apparatus of Figure 4 including p-type regions. This Figure shows a constant current supply connected to the semiconductor apparatus. An IGBT 40, a p-type region 21, and a temperature sensor 50 are arranged side by side from the left hand side of the Figure. In temperature sensor 50, parasitic pnp and npn transistors constitute a pnpn parasitic thyristor. A constant current supply 24 is connected as shown in Figure 8. Another emitter terminal 13a is connected for making a main current flow through IGBT 40. Emitter terminal 13a is indispensable especially when it is necessary to make a very high current flow through the IGBT.

Figure 9(a) is a set of curves relating the forward voltage of the temperature sensor with the forward current of up to 20 mA with the temperature as a parameter. Figure 9(b) is a set of curves relating the forward voltage of the temperature sensor with the forward current of up to 2 mA with the temperature as a parameter. The abscissa of Figure 9(a) is divided every 0.2 V, and the abscissa of Figure 9(b) every 0.1 V.

Figure 10 shows the relationship between the forward voltage and the junction temperature based on the data of Figs. 9(a) and 9(b). To detect a temperature from the forward voltage, it is preferable to use a current value at which the forward voltage changes greatly with temperatures. A current of 0.2 mA (a sensing current value) from the constant current supply is adopted. For a current of 0.2 mA, the temperature of the temperature sensor, i.e. the IGBT temperature, is 125°C when the forward voltage of the temperature sensor (a detected voltage value) is 0.6 V. Therefore, the IGBT is prevented from breakdown caused by overheating, by operating an external protecting circuit when the forward voltage reaches a predetermined value, 0.6 V for example, so that the IGBT temperature may not exceeds 125°C.

IPMs exhibiting the same effects with those of the foregoing embodiments may be obtained by using a p-type substrate on which each region is disposed using an opposite conductivity type to that of the foregoing embodiments.

As described above, a temperature sensor is integrated with an IGBT on one semiconductor substrate in the semiconductor apparatus of the invention. Therefore, the IGBT is securely protected against overheating, since the temperature of the IGBT is detected accurately in a short time. The effects of the invention are multiplied by connecting multiple pn diodes to constitute a temperature sensor of increased sensitivity.

## Claims

1. A semiconductor apparatus comprising:
a semiconductor substrate of a first conductivity type;
an insulated gate semiconductor device including
a well region of a second conductivity type in a first surface portion of said semiconductor substrate,
an emitter region of said first conductivity type in said well region, and
an emitter electrode on said emitter region;and
a pn diode including
an anode region of said second conductivity type selectively formed in a second surface portion of said semiconductor substrate, said anode region being separated apart laterally from said well region,
an anode electrode on said anode region,
a cathode region of said first conductivity type selectively formed in said anode region, and
a cathode electrode on said cathode region, said cathode electrode being connected to said emitter electrode.

2. A semiconductor apparatus according to claim 1, wherein said well region and said anode region have a same dopant concentration and a same depth; and said emitter region and said cathode region have a same dopant concentration and a same depth.

3. A semiconductor apparatus according to claim 1, wherein said cathode region is concentrically formed with said anode region.

4. A semiconductor apparatus according to claim 3, further comprising:
a region of said second conductivity type surrounding said anode region, said region of said second conductivity type being spaced apart laterally from said insulated gate semiconductor device;and
a metal electrode on said region of said second conductivity type, said metal electrode being connected to said cathode electrode and said emitter electrode.

5. A semiconductor apparatus according to claim 1, further comprising:
an anode terminal connected to said anode electrode;
an emitter terminal connected to said emitter electrode;
a constant current supply including
a positive electrode connected to said anode terminal, and
a negative electrode connected to said emitter terminal,
whereby to make a current flow from said anode region to said cathode region;and
a temperature sensing terminal for sensing said lateral insulated gate semiconductor device's temperature from said anode electrode's potential, said temperature sensing terminal being connected to said anode electrode.

6. A semiconductor apparatus comprising:
a semiconductor substrate of a first conductivity type;
an insulated gate semiconductor device including a well region of a second conductivity type in a first surface portion of said semiconductor substrate,
an emitter region of said first conductivity type in said well region, and
an emitter electrode on said emitter region;
two or more pn diodes in a second surface portion of said semiconductor substrate,
said two or more pn diodes being separated apart laterally from said insulated semiconductor device,
each of said two or more pn diodes including
an anode region of said second conductivity type,
an anode electrode on said anode region,a cathode region of said first conductivity type selectively formed in said anode region, and
a cathode electrode on said cathode region;andmetal films selectively formed on said semiconductor substrate with an insulation film interposed in-between, each of said metal film connecting said anode electrode of one of said two or more pn diodes to said cathode electrode of an adjacent one of said two or more pn diodes, whereby to connect said two or more pn diodes in series.

7. A semiconductor apparatus according to claim 6, wherein said well region and said anode regions have a same dopant concentration and a same depth; and said emitter region and said cathode regions have a same dopant concentration and a same depth.

8. A semiconductor apparatus according to claim 6, wherein each of said cathode regions is concentrically formed with each of said anode regions.

9. A semiconductor apparatus according to claim 8, further comprising
a region of said second conductivity type surrounding said anode regions, said region of said second conductivity type being spaced apart laterally from said insulated gate semiconductor device;and
a metal electrode on said region of said second conductivity type. said metal electrodes being connected to said emitter electrode and said cathode located at an end of said series connection of said pn diodes.

10. A semiconductor apparatus according to claim 6, further comprising an anode terminal connected to said anode electrode located at an end of said series connection of said pn diodes;
an emitter terminal connected to said emitter electrode;
a constant current supply including a positive electrode connected to said anode terminal, and
a negative electrode connected to said emitter terminal, whereby to make a current flow from said anode region to said cathode region of said pn diodes;and
a temperature sensing terminal for sensing said lateral insulated gate semiconductor device's temperature from a voltage drop across said two or more pn diodes, said temperature sensing terminal being connected to said anode electrode located at said end of said series connection.
